# EUROPEAN PATENT SPECIFICATION

(11) **EP 1 524 740 B1**
(45) Date of publication and mention of the grant of the patent: **12.08.2009**
(21) Application number: 04256329.6
(22) Date of filing: 14.10.2004
(51) Int. Cl.: H01S 5/00

(54) **III-V group GaN-based semiconductor device and method of manufacturing the same**
Halbleitervorrichtung der Gruppe III-V auf GaN-Basis und ihr Herstellungsverfahren
Dispositif semiconducteur du groupe III-V à bas de GaN et sa méthode de fabrication

(30) Priority: 17.10.2003 KR 2003072499
(43) Date of publication of application: 20.04.2005
(73) Proprietor: SAMSUNG ELECTRONICS CO., LTD., Suwon-city, Gyeonggi-do (KR)
(72) Inventor: Sakong, Tan,, Gyeonggi-do (KR); Lee, Sung-nam, Suwon-si, Gyeonggi-do (KR); Paek, Ho-sun, Suwon-si, Gyeonggi-do (KR); Son, Joong-kon, Suwon-si, Gyeonggi-do (KR); Lee, Won-seok, Eunpyeong-gu, Seoul (KR)
(74) Representative: Greene, Simon Kenneth

(56) References cited:
- WO-A-03/077391
- US-A- 6 028 877
- US-A1- 2001 030 329
- US-A1- 2002 085 603

## Description

The present invention relates to a III - V group GaN-based semiconductor device and a method of manufacturing the same, and more particularly, to a III-V group GaN-based semiconductor device and a method of manufacturing the same, which can protect an active layer from thermal shock during formation of a p-type semiconductor layer.

During the manufacturing of a III-V group GaN-based semiconductor device, after an active layer is grown, a reaction temperature must be raised to a high temperature of about 1050 °C before the growth of a p-type compound semiconductor layer.

Applying the high temperature to an exposed top surface of the active layer damages the active layer, thus deteriorating interfacial characteristics between the active layer and the p-type compound semiconductor layer.

Techniques of preventing the damage to the active layer and the deterioration of the interfacial characteristics are necessary. For this purpose, U.S. Patent Application No. 20020053676 AA discloses a semiconductor device in which an InGaN protection layer having a thickness of about 200 to 500 Å is formed directly on a grown active layer to protect the active layer, a reaction temperature is raised to a high temperature of about 1100 °C, and then a p-type semiconductor layer is formed.

The InGaN protection layer is formed to protect the active layer from a high-temperature atmosphere, but cannot sufficiently suppress damage to the active layer. Rather, the InGaN protection layer leads to the formation of a gradually degraded layer, which deteriorates the operating performance of the semiconductor device.

Japanese Patent Laid-open Publication No. 9-36429 proposes another method for preventing deterioration of an active layer due to a high temperature. In this case, after the active layer is grown, a low-temperature AlGaN protection layer is grown to a thickness of about 10 to 50 Å. US 2001 0 030 329 A1 discloses a semiconductor device with an AlGaN diffusion blocking layer.

However, in this method, the AlGaN protection layer itself is not resistant to the high temperature enough to protect the active layer.

According to an aspect of the present invention, there is provided a III-V group GaN-based semiconductor device including an n-type GaN-based compound semiconductor layer; an active layer comprising alternately stacked quantum wells and barrier layers disposed on the n-type GaN-based compound semiconductor layer; an Al GaN diffusion blocking layer disposed on the active layer; an InGaN sacrificial layer formed on the Al GaN diffusion blocking layer; and a p-type GaN-based compound semiconductor layer disposed on the InGaN sacrificial layer.

According to another aspect of the present invention, there is provided a method of manufacturing a III-V group GaN-based semiconductor device. The method includes growing an n-type GaN-based compound semiconductor layer on a substrate; growing an active layer having a multiple quantum well on the n-type GaN-based compound semiconductor layer; growing an AlₓGaN diffusion blocking layer on the active layer; growing an InGaN sacrificial layer on the diffusion blocking layer; and growing a p-type GaN-based compound semiconductor layer on the InGaN sacrificial layer.

The present invention provides a III-V group GaN-based semiconductor device and a method of manufacturing the same, which can prevent deterioration of an active layer due to a rise in temperature.

The growing of the diffusion blocking layer and the growing of the sacrificial layer may be performed immediately after the growing of the active layer at the same temperature as the temperature at which the active layer is grown.

After the sacrificial layer is grown, a reaction temperature may be raised to a temperature appropriate for growing the p-type GaN-based compound semiconductor layer.

The sacrificial layer may be formed to a thickness of about 20 to 200 Å, preferably 50 Å. Also, the sacrificial layer may be formed of 10 % or less, preferably 1 % or less, by weight of ln.

The diffusion blocking layer may be formed with a different thickness, depending on its Al composition. For more than 10% Al composition, up to 50%, the layer thickness may be formed of 5∼100Å, preferably 20Å. For less than 10% Al composition of diffusion blocking layer, the thickness of diffusion blocking layer should be increased, up to 500 Å for 1% Al composition. Preferably, 300Å thickness of diffusion blocking layer is formed at 4% Al.

The above and other features and advantages of the present invention will become more apparent by describing in detail exemplary embodiments thereof with reference to the attached drawings in which:
FIG. 1 is a schematic cross-sectional view of a laser diode (LD) according to the present invention;
FIG. 2 is an energy band diagram of the LD shown in FIG. 1;
FIG. 3 is a transmission electron microscope (TEM) image of a semiconductor stack layer formed by stacking a diffusion blocking layer and a sacrificial layer on an active layer according to the present invention;
FIG. 4 is an atomic force microscope (AFM) image of the sacrificial layer shown in FIG. 3;
FIG. 5 is a TEM image of a Nitride-based LD including a conventional protection layer;
FIG. 6 is an AFM image of a sample that is obtained by growing a conventional protection layer at a growth rate of about 0.3 Å/s, stopping the growth of the protection layer, raising a reaction temperature to 1050 °C, maintaining the reaction temperature for a predetermined amount of time, and lowering the reaction temperature;
FIG. 7 is an AFM image of a sample obtained by growing a conventional protection layer at a growth rate of about 4.5 Å/s, stopping the growth of the protection layer, raising a reaction temperature to 1050 °C, maintaining the reaction temperature for a predetermined amount of time, and lowering the reaction temperature; and
FIG. 8 is a graph showing internal quantum efficiencies of a sample according to the present invention and conventional samples.

The present invention will now be described more fully with reference to the accompanying drawings, in which exemplary embodiments of the invention are shown.

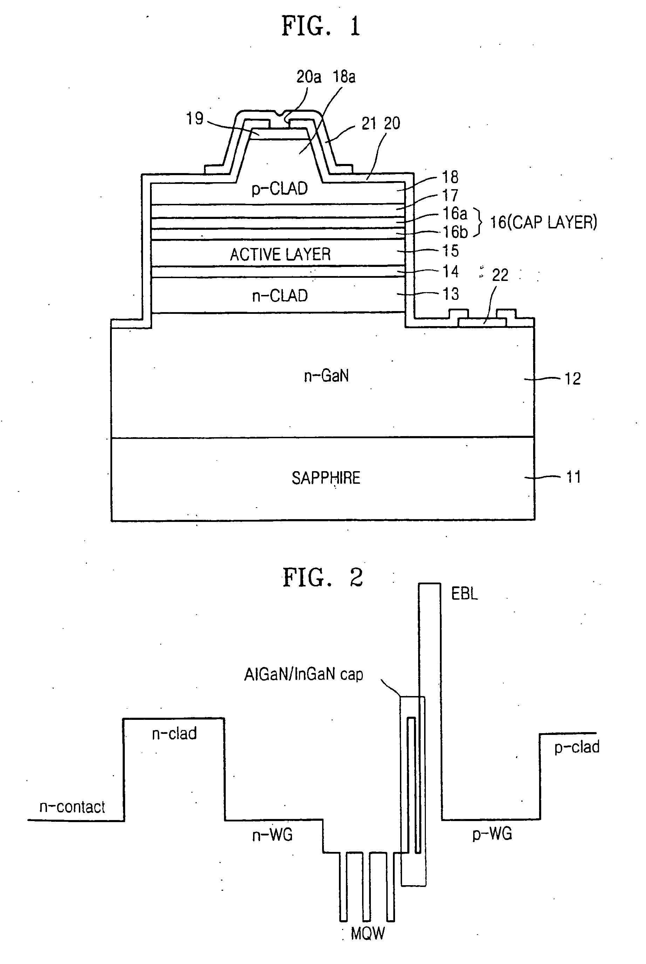

FIG. 1 is a schematic cross-sectional view of a GaN-based III-V group semiconductor device, i.e., a laser diode (LD), according to the present invention, and FIG. 2 is an energy band diagram of the LD shown in FIG. 1.

Referring to FIG. 1, an InGaN active layer 15 forms a sandwich structure with a p-type compound semiconductor stack and an n-type compound semiconductor stack disposed on and under the InGaN active layer 15. The sandwich structure is disposed on a substrate, for example, a sapphire substrate 11. The substrate 11 may be removed if required. If the substrate 11 is removed, an n-GaN contact layer 12, which is disposed on the substrate 11, may function as a substrate.

A cap layer 16 is interposed between the active layer 15 and the p-type compound semiconductor stack. The cap layer 16 includes a single InGaN sacrificial layer 16a disposed on a single AlGaN diffusion blocking layer 16b. Alternatively, the cap layer 16 may be formed by sequentially stacking 20 or less combinations of the diffusion blocking layer 16b stacked on the sacrificial layer 16a and 20.

The diffusion blocking layer 16b prevents diffusion of indium from the active layer 15, and the sacrificial layer 16a protects the diffusion blocking layer 16b. When manufacturing the LD, the sacrificial layer 16a protects the diffusion blocking layer 16b from heat applied during the formation of the p-type semiconductor layer. As a result, the sacrificial layer 16a is partially removed with a small amount of the sacrificial layer 16a remaining on the diffusion blocking layer 16b. The diffusion blocking layer 16a is grown to a thickness of about 5 to 100 A, preferably 20 A. For less than 10% Al compostion of diffusion blocking layer, the thickness of diffusion blocking layer should be increased, up to 500 Å for 1% Al composition. Preferably, 300Å thickness of diffusion blocking layer is formed at 4% Al. The sacrificial layer 16a is grown to a thickness of about 20 to 200 Å, preferably 50 Å, since approximately 30 to 70 Å of the sacrificial layer 16a is desorbed depending on growth conditions during a rise in the temperature.

Hereinafter, the structure of the LD will be described in detail with reference to FIG. 1.

The n-GaN lower contact layer 12 is stacked on the sapphire substrate 11. A multiple semiconductor layer is disposed on the lower contact layer 12 to form a mesa structure. That is, an n-GaN/AlGaN lower clad layer 13, an n-GaN lower waveguide layer 14, the InGaN active layer 15, the cap layer 16, a p-GaN upper waveguide layer 17, and a p-GaN/AlGaN upper clad layer 18 are sequentially stacked on a top surface of the n-GaN lower contact layer 12. The n-GaN/AlGaN lower clad layer 13 and the p-GaN/AlGaN upper clad layer 18 have lower refractive indexes than the n-GaN lower waveguide layer 14 and the p-GaN upper waveguide layer 17, respectively, and the n-GaN lower waveguide layer 14 and the p-GaN upper waveguide layer 17 have lower refractive indexes than the active layer 15. In the mesa structure, a protruding ridge 18a having a predetermined width is formed in the center of a top surface of the p-GaN/AlGaN upper clad layer 18 to provide a ridge wave guide structure, and a p-GaN upper contact layer 19 is formed on top of the ridge 18a. A buried layer 20 having a contact hole 20a, which acts as a passivation layer, is disposed on the p-GaN/AlGaN upper clad layer 18. The contact hole 20a of the buried layer 20 corresponds to a top portion of the upper contact layer 19 formed on the ridge 18a, and an outer portion of the contact hole 20a overlaps an outer portion of the upper contact layer 19.

The p-type compound semiconductor layer disposed on the active layer 16 may further include an electron blocking layer (EBL), which prevents flow of electrons from the active layer 15 into the p-type compound semiconductor layer, and a phase matching layer. Since the EBL and the phase matching layer are general elements that do not limit the technical spirit of the present invention, they are not shown in FIG. 1 for clarity of explanation. However, the EBL is shown in the energy band diagram of FIG. 2.

A p-type electrode 21, which is a multiple layer including a Zn-based stack layer, is formed on the buried layer 20. The p-type electrode 21 contacts the upper contact layer 19 via the contact hole 19a of the buried layer 20. An n-type electrode 22 is formed on a stepped portion disposed on one side of the lower contact layer 12. The ridge wave guide structure disposed on the upper clad layer 17 limits a current flowing to the active layer 15. Thus, the width of a resonance region is limited, thereby stabilizing a transverse mode and reducing an operating current.

To manufacture a conventional Nitride-based semiconductor laser device, a multiple GaN-based semiconductor layer is formed on a sapphire substrate, a ridge where a current is supplied is formed by dry etching, and a mesa structure is formed on an n-GaN lower contact layer to expose the n-GaN lower contact layer and form a resonance surface.

On the other hand, in the present invention, after the active layer 15 is grown with a multiple quantum well (MQW), the cap layer 16 is formed by sequentially stacking the AlGaN diffusion blocking layer 16b and the InGaN sacrificial layer 16a on the active layer 15 without varying a reaction temperature, the reaction temperature is then raised to a high temperature of, for example, 1050 °C, and then the p-type semiconductor stack layer is grown on the InGaN sacrificial layer 16a. The n-type compound semiconductor stack layer disposed under the active layer 15 can be grown at a temperature of about 1050 °C, and the active layer 15 is grown after the reaction temperature is lowered to 780 °C.

In the present invention, deterioration of an InGaN/GaN active layer during high-temperature growth of the p-type GaN-based compound semiconductor stack layer is effectively prevented. Thus, an operating current is maintained at an appropriate level, and lifetime of the LD can be extended.

In a method of manufacturing an LD according to the present invention, after the active layer 15 is formed, the diffusion blocking layer 16b and the sacrificial layer 16a are sequentially grown at a temperature between 770 ∼ 900 °C, for example at the same temperature as the temperature at which the active layer 15 is grown, for example, at 780 °C. The diffusion blocking layer 16b is formed of AlₓGa₁₋ₓN [0.01≤x≤0.5] or AlₓIn_{y}Ga_{1-x-y}N [0.01≤x≤0.5, 0.01≤y≤0.1], and the sacrificial layer 16a is formed of InₓG₁₋ₓN [0≤x≤0.1]. Thereafter, a reaction temperature is raised to a high temperature of, for example, 1050 °C, and the p-type compound semiconductor stack layer is grown using AlₓIn_{y}Ga_{z}N [0≤x≤1, 0≤y≤1, 0≤z≤1, and x+y+z = 1]. As stated above, the diffusion blocking layer 16b is grown to a thickness of about 5 to 500 Å, preferably 20 Å or less. The sacrificial layer 16a is grown to a thickness of about 20 to 200 Å, preferably 50 Å, since approximately 30 to 70 Å of the sacrificial layer 16a is desorbed depending on growth conditions when raising the temperature.

In the present invention, the diffusion blocking layer 16b stably prevents diffusion of indium from the active layer 15, having both wells and barriers, at the high temperature. The sacrificial layer 16a, which is formed of InₓG₁₋ₓN [0<x<0.1], is sacrificially damaged to prevent deterioration of the diffusion blocking layer 16b disposed thereunder. Thus, crystallinity of the diffusion blocking layer 16b can be stabilized.

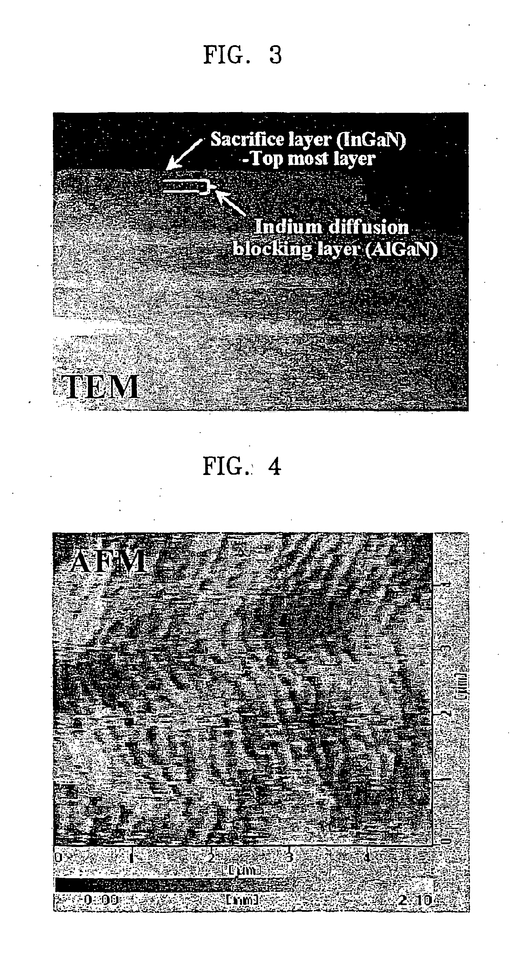

FIG. 3 is a transmission electron microscope (TEM) image of a semiconductor stack layer formed by stacking an AlGaN diffusion blocking layer and an InGaN sacrificial layer on an active layer having an MQW according to the present invention, and FIG. 4 is an atomic force microscope (AFM) image of the InGaN sacrificial layer shown in FIG. 3. In FIGS. 3 and 4, a sample was obtained by growing only an active layer and a cap layer .to observe both TEM and AFM images at the same time. To form the sample, the cap layer was grown, a growth process was stopped, and then the temperature of a reactor was raised to 1050 °C, maintained for a predetermined amount of time, and then dropped.

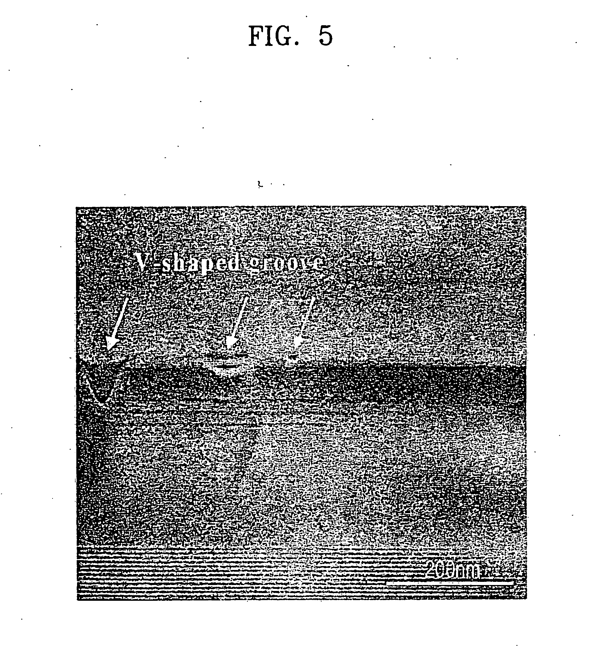

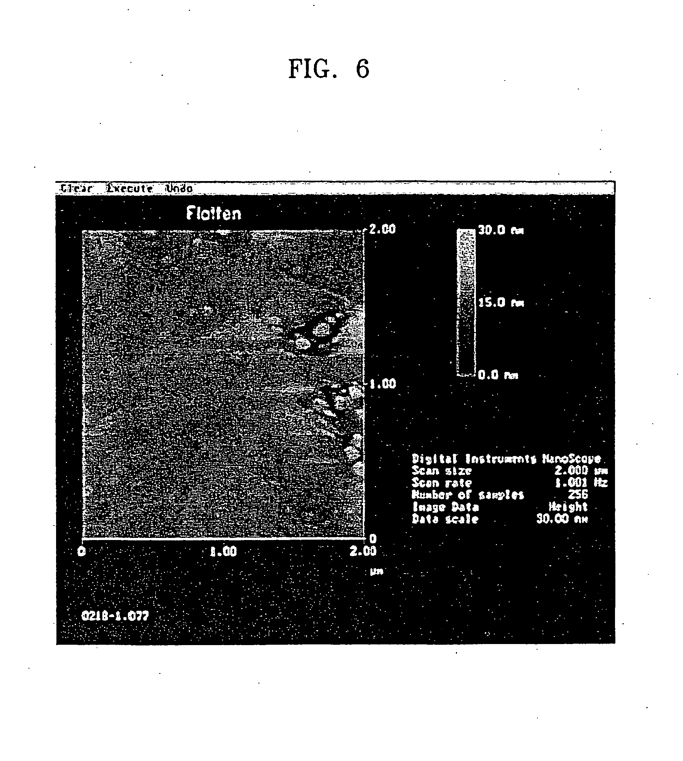

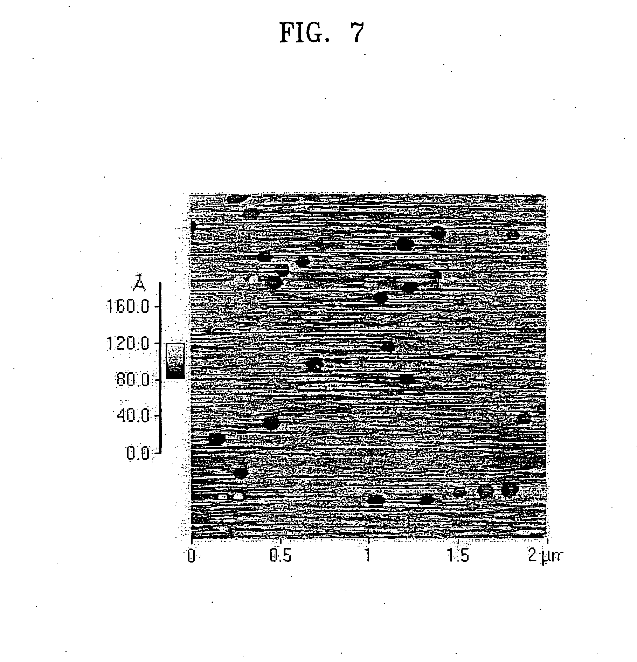

FIG. 5 is a TEM image of a cross-section of an N-based laser semiconductor structure including a conventional AlGaN protection layer that is grown at a rate of about 4.5 Å/s, and FIGS. 6 and 7 are AFM images of samples including conventional AlGaN protection layers grown at growth rates of about 0.3 Å/s and about 4.5 Å/s, respectively. In FIGS. 6 and 7, to observe the AFM images, only an active layer and a protection layer of the above-described laser structure were grown. After the protection layer was grown, a reaction temperature was raised to 1050 °C, maintained for a predetermined amount of time, and then dropped. In the conventional case shown in FIG. 5, groove type defects were generated in the active layer and the protection layer. However, in the case of an embodiment of the present invention shown in FIG. 3, clean sectional profiles containing no defects were obtained.

Also, to determine if the groove type defects were generated due to poor crystallinity of the protection layer, the AFM images were observed by varying the growth rates as shown in FIGS. 6 and 7. Based on the results, defects were found in both cases, although the shapes of the defects were different. Therefore, it can be concluded that the crystallinity of the protection layer greatly affects growth of an N-based semiconductor laser device, but even a protection layer having very good crystallinity cannot prevent the generation of groove type defects. Unlike in the present invention, in the conventional case, the protection layer is not protected against a rise in the temperature of a reactor, thus resulting in the generation of the groove type defects. The cap layer including the diffusion blocking layer and the sacrificial layer according to the present invention do not transmit to the active layer heat caused by the rise in the temperature and enable the absorption of heat by the cap layer. In other words, the low-temperature AlGaN diffusion blocking layer and the sacrificial layer can suppress the generation of groove type defects in the stack layers including the active layer during a high-speed rise in temperature. This is because InₓGa₁₋ₓN [0.01≤x≤0.1], which is relatively easily degraded, is uniformly deteriorated on the entire surface.

Thus, in the present invention, not only is the deterioration of an InGaN active layer prevented, but also the generation of groove type defects that preclude techniques of growing AlGaN diffusion blocking layers from being used. In addition, as shown in the TEM image of FIG. 3 and the AFM image of FIG. 4, a clean crystalline layer having no defects can be obtained.

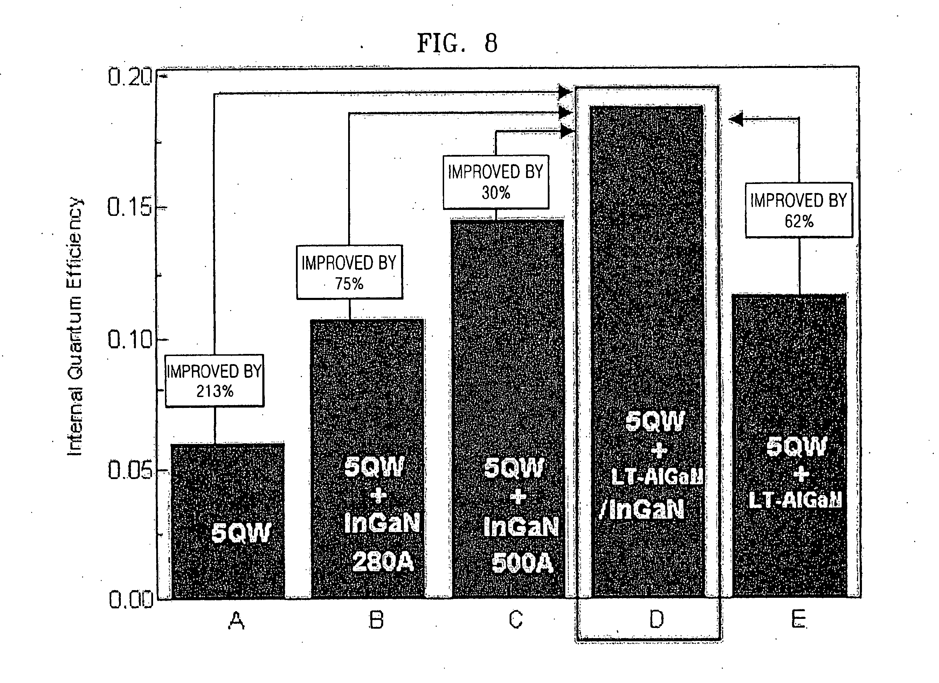

FIG. 8 is a graph showing internal quantum efficiencies of a sample according to the present invention and conventional samples. The internal quantum efficiencies of the samples were measured using temperature dependent photo luminescence. The internal quantum efficiency is given by the intensity of photo luminescence measured at room temperature divided by the intensity of photo luminescence measured at 10 K.

FIG. 8 shows not only a relationship between a rise in temperature of a reactor and the quantum efficiency of an active layer after the active layer is grown, but also comparisons of quantum efficiencies of conventional active layers and an active layer according to the present invention.

Referring to FIG. 8, the samples A, B, C, and D were obtained by growing an active layer, stopping a growth process, raising the temperature of a reactor to 1050 °C, maintaining the reactor at 1050 °C for a predetermined amount of time, and then dropping the temperature of the reactor. Then, the quantum efficiency of the sample was measured using the temperature dependent photo luminescence. Samples A to E have the following characteristics. The sample A has a quintuple quantum well 5QW without a protection layer, and the sample B has a quintuple quantum well 5QW and includes an InGaN protection layer having a thickness of 280 Å between an active layer and a growth stop point. The sample C includes an InGaN protection layer having a thickness of 500 Å between an active layer and a growth stop point. The sample D, which was obtained according to the present invention, includes an AlGaN diffusion blocking layer and an InGaN sacrificial layer (i.e., a protection layer) on a quintuple quantum well 5QW (i.e., between an active layer and a growth stop point). The sample E has a quintuple quantum well 5QW and includes only an AlGaN diffusion blocking layer disposed thereon (i.e., between an active layer and a growth stop point).

Referring to FIG. 8, the sample D according to the present invention, which includes the AlGaN diffusion blocking layer and an undoped InGaN sacrificial layer (or an Mg doped InGaN sacrificial layer), had between a 30 to 213 % higher internal quantum efficiency than the conventional samples A, B, C, and E, each of which includes one of AlGaN and InGaN. For example, the sample D had a 213% higher internal quantum efficiency than the sample A that included neither a sacrificial layer nor a diffusion blocking layer, a 30% higher internal quantum efficiency than the sample C having the 500Å-thick InGaN diffusion blocking layer, and a 75% higher internal quantum efficiency than the sample B having the 280 Å-thick InGaN diffusion blocking layer.

By extrapolating the results shown in FIG. 8, it can be determined that that the rise in temperature of the reactor lowers the quantum efficiency of the active layer after the active layer is grown. Normally, the reason that the intensity of photo luminescence measured at room temperature divided by the intensity of photo luminescence measured at 10 K, i.e., internal quantum efficiency, does not reach 0 is that non-radiative recombination centers are activated at high temperatures. Accordingly, as the internal quantum efficiency approximates 1, a likelihood of converting applied power into light increases. Referring to FIG. 8, the generation of new non-radiative recombination centers due to a rise in temperature in the respective samples can be compared. As can be seen from FIG. 8, the sample D according to the present invention had a higher internal quantum efficiency than the conventional samples. Therefore, the deterioration of quantum efficiency due to a rise in temperature can be prevented more effectively in the present invention than in the conventional samples.

As described above, a III-V group GaN-based semiconductor device of the present invention includes an AlGaN diffusion blocking layer, which can be grown at a low temperature, and an InGaN sacrificial layer, which protects the diffusion blocking layer, interposed between an active layer grown at a low temperature and an p-type compound semiconductor stack layer grown at a high temperature. Thus, the semiconductor device can have a high-quality crystalline growth structure having good interfacial characteristics between the active layer and the p-type compound semiconductor layer.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A III-V group GaN-based semiconductor device comprising:
an n-type GaN-based compound semiconductor layer;
an active layer comprising alternately stacked quantum wells and barrier layers disposed on the n-type GaN-based compound semiconductor layer;
an Al GaN diffusion blocking layer disposed on the active layer;
a p-type GaN-based compound semiconductor layer
**characterized in that** the device further comprises :
an InGaN sacrificial layer formed on the Al GaN diffusion blocking layer and that the p-type GaN-based compound semiconductor layer is disposed on the InGaN sacrificial layer.

2. The device of claim 1, wherein the sacrificial layer has a thickness of about 20 to 200 Å.

3. The device of claim 1 or 2, wherein the sacrificial layer contains 10 % or less by weight of In.

4. The device of claim 1, 2 or 3, wherein the diffusion blocking layer has a thickness of about 5 to 500 Å.

5. The device of any preceding claim, wherein the diffusion layer contains 1 to 50 % by weight of Al.

6. A method of manufacturing a III-V group GaN-based semiconductor device, the method comprising:
growing an n-type GaN-based compound semiconductor layer on a substrate;
growing an active layer having a multiple quantum well on the n-type GaN-based compound semiconductor layer;
growing an AlₓGaN diffusion blocking layer on the active layer;
growing a p-type GaN-based compound semiconductor layer
**characterized in that** the method further comprises:
- growing a InGaN sacrificial layer on the diffusion blocking layer and that said p-type GaN-based compound semiconductor layer is grown on said InGaN sacrificial layer.

7. The method of claim 6, wherein the growing of the diffusion blocking layer and the growing of the sacrificial layer are performed immediately after the growing of the active layer at the same temperature as the temperature at which the active layer is grown.

8. The method of claim 6 or 7, wherein after the sacrificial layer is grown, a reaction temperature is raised to a temperature appropriate for growing the p-type GaN-based compound semiconductor layer.

9. The method of any of claims 6 to 8, wherein the sacrificial layer is formed to a thickness of about 30 to 200 Å.

10. The method of any of claims 6 to 9, wherein the sacrificial layer is formed of 10 % or less by weight of In.

11. The method of any of claims 6 to 10, wherein the diffusion blocking layer is formed to a thickness of about 5 to 500 Å.

12. The method of any of claims 6 to 11, wherein the diffusion layer is formed of 1 to 50 % by weight of Al.

## Patentansprüche

1. Halbleiterbauelement der Gruppe III-V auf GaN-Basis, umfassend:
eine Halbleiterschicht vom n-Typ auf GaN-Verbindungsbasis,
eine aktive Schicht, die abwechselnd aufgeschichtete Quantenmulden und Barriereschichten umfasst, die auf der Halbleiterschicht vom n-Typ auf GaN-Verbindungsbasis angeordnet ist,
eine auf der aktiven Schicht angeordnete AIGaN-Diffusionssperrschicht,
eine Halbleiterschicht vom p-Typ auf GaN-Verbindungsbasis,
**dadurch gekennzeichnet, dass** das Bauelement ferner umfasst:
eine InGaN-Opferschicht, die auf der AlGaN-Diffusionssperrschicht ausgebildet ist, und dass die Halbleiterschicht vom p-Typ auf GaN-Verbindungsbasis auf der InGaN-Opferschicht angeordnet ist.

2. Bauelement nach Anspruch 1, wobei die Opferschicht eine Dicke von ungefähr 20 bis 200 Å aufweist.

3. Bauelement nach Anspruch 1 oder 2, wobei die Opferschicht 10 Gew.-% oder weniger an In enthält.

4. Bauelement nach Anspruch 1, 2 oder 3, wobei die Diffusionssperrschicht eine Dicke von ungefähr 5 bis 500 Å aufweist.

5. Bauelement nach einem der vorhergehenden Ansprüche, wobei die Diffusionsschicht 1 bis 50 Gew.-% an Al enthält.

6. Verfahren zur Herstellung eines Halbleiterbauelements der Gruppe III-V auf GaN-Basis, wobei das Verfahren umfasst:
Züchten einer Halbleiterschicht vom n-Typ auf GaN-Verbindungsbasis auf einem Substrat,
Züchten einer aktiven Schicht mit mehreren Quantenmulden auf der Halbleiterschicht vom n-Typ auf GaN-Verbindungsbasis,
Züchten einer AlₓGaN-Diffusionssperrschicht auf der aktiven Schicht,
Züchten einer Halbleiterschicht vom p-Typ auf GaN-Verbindungsbasis,
**dadurch gekennzeichnet, dass** das Verfahren weiter umfasst:
Züchten einer InGaN-Opferschicht auf der Diffusionssperrschicht und dadurch, dass die Halbleiterschicht vom p-Typ auf GaN-Verbindungsbasis auf der InGaN-Opferschicht gezüchtet wird.

7. Verfahren nach Anspruch 6, wobei das Züchten der Diffusionssperrschicht und das Züchten der Opferschicht unmittelbar nach dem Züchten der aktiven Schicht bei der gleichen Temperatur wie die Temperatur, bei der die aktive Schicht gezüchtet wird, durch geführt wird.

8. Verfahren nach Anspruch 6 oder 7, wobei, nachdem die Opferschicht gezüchtet ist, eine Reaktionstemperatur auf eine geeignete Temperatur zum Züchten der Halbleiterschicht vom p-Typ auf GaN-Verbindungsbasis erhöht wird.

9. Verfahren nach einem der Ansprüche 6 bis 8, wobei die Opferschicht auf eine Dicke von ungefähr 30 bis 200 Å gebildet wird.

10. Verfahren nach einem der Ansprüche 6 bis 9, wobei die Opferschicht aus 10 Gew.-% oder weniger an In gebildet wird.

11. Verfahren nach einem der Ansprüche 6 bis 10, wobei die Diffusionssperrschicht auf eine Dicke von ungefähr 5 bis 500 Å gebildet wird.

12. Verfahren nach einem der Ansprüche 6 bis 11, wobei die Diffusionsschicht aus 1 bis 50 Gew.-% an Al gebildet wird.

## Revendications

1. Dispositif semi-conducteur à base de GaN des Groupes III-V comprenant :
- une couche semi-conductrice composite de type n à base de GaN ;
une couche active comportant, empilés alternativement, des puits quantiques et des couches barrières disposées sur la couche semi-conductrice composite de type n à base de GaN ;
- une couche AlGaN de blocage de diffusion disposée sur la couche active ;
- une couche semi-conductrice composite de type p à base de GaN
**caractérisé en ce que** le dispositif comporte en outre :
- une couche sacrificielle InGaN formée sur la couche AlGaN de blocage de diffusion
et **en ce que** la couche semi-conductrice composite de type p à base de GaN est disposée sur la couche sacrificielle InGaN.

2. Le dispositif selon la revendication 1, dans lequel la couche sacrificielle a une épaisseur d'environ 20 à 200 Ǻ.

3. Le dispositif selon la revendication 1 ou 2, dans lequel la couche sacrificielle contient 10% ou moins en poids de In.

4. Le dispositif selon la revendication 1, 2 ou 3, dans lequel la couche de blocage de diffusion a une épaisseur d'environ 5 à 500 À.

5. Le dispositif selon l'une des revendications précédentes, dans lequel la couche de blocage de diffusion contient de 1 à 50% en poids de Al.

6. Procédé de fabrication d'un dispositif semi-conducteur à base de GaN des Groupes III-V, comportant :
- la croissance d'une couche semi-conductrice composite de type n à base de GaN sur un substrat ;
- la croissance d'une couche active ayant un puits quantique multiple sur la couche semi-conductrice composite de type n à base de GaN ;
- la croissance d'une couche AlₓGaN de blocage de diffusion sur la couche active ;
- la croissance d'une couche semi-conductrice composite de type p à base de GaN
**caractérisé en ce que** le procédé comprend en outre :
- la croissance d'une couche sacrificielle InGaN formée sur la couche de blocage de diffusion et **en ce que**
ladite couche semi-conductrice composite de type p à base de GaN croit sur ladite couche InGaN sacrificielle.

7. Le Procédé selon la revendication 6 dans lequel la croissance de la couche de blocage de diffusion et celle de la couche sacrificielle sont effectuées immédiatement après la croissance de la couche active à la même température que celle à laquelle la couche active croit.

8. Le Procédé selon la revendication 6 ou 7 dans lequel après la croissance de la couche sacrificielle, une température de réaction est élevée à une température appropriée pour la croissance de ladite couche semi-conductrice composite de type p à base de GaN.

9. Le procédé selon l'une des revendications 6 à 8, dans lequel la couche sacrificielle est formée à une épaisseur d'environ 30 à 200 Å.

10. Le procédé selon l'une des revendications 6 à 9, dans lequel la couche sacrificielle est formée de 10% ou moins en poids de In.

11. Le procédé selon l'une des revendications 6 à 10, dans lequel la couche de blocage de diffusion est formée à une épaisseur de 5 à 500 Å.

12. Le procédé selon l'une des revendications 6 à 11, dans lequel la couche de blocage de diffusion est formée de 1 à 50% en poids de Al.
